# FASCICULE DE BREVET EUROPEEN

(11) **EP 0 645 887 B1**
(45) Date de publication et mention de la délivrance du brevet: **15.01.1997**
(21) Numéro de dépôt: 94402092.4
(22) Date de dépôt: 20.09.1994
(51) Int. Cl.: H03K 3/64, H04N 3/233

(54) **Circuit de production de signaux de balayage avec générateur de signaux périodiques**
Schaltung zur Erzeugung von Ablenksignalen mit Generator periodischer Signale
Scanning circuit with periodic signal generator

(30) Priorité: 29.09.1993 FR 9311563
(43) Date de publication de la demande: 29.03.1995
(73) Titulaire: SGS-THOMSON MICROELECTRONICS S.A., 94250 Gentilly (FR)
(72) Inventeur: Alves de Lima, Jader, c/o Cabinet Ballot-Schmit, F-75116 Paris (FR); Lee, Yong Uk,c/o Cabinet Ballot-Schmit, F-75116 Paris (FR); Nunzi, Pierre, c/o Cabinet Ballot-Schmit, F-75116 Paris (FR)
(74) Mandataire: Schmit, Christian Norbert Marie

(56) Documents cités:
- EP-A- 0 052 032
- GB-A- 1 353 147
- GB-A- 2 076 571
- GB-A- 2 101 459
- US-A- 3 758 825
- INSTRUMENTS AND EXPERIMENTAL TECHNIQUES., vol.29, no.5,1, Septembre 1986, NEW YORK US pages 1101 - 1102 GOLOVANOV ET AL 'Analog-digital generator of periodic signals of arbitrary shape'
- O.LIMANN et al.: "Fernsehtechnik ohne Ballast", éditions Franzis, 1991, Munich, Allemagne, pages 498-523
- U.TIETZE et Ch.SCHENK: "Halbleiter-Schaltungstechnik", éditions Springer, 1983, Berlin, Allemagne, pages 250-251

## Description

La présente invention a pour objet un circuit de production de signaux de balayage avec un générateur de signaux périodiques, de période quelconque mais de forme donnée. Elle peut trouver son application dans tous les domaines et notamment dans le domaine de la télévision. Dans celui-ci, elle servira de préférence à permettre la correction d'un balayage horizontal. L'invention va être décrite pour la production d'un signal numérique mis par ailleurs sous une forme analogique à l'issue du traitement. Cependant, le signal pourrait être directement un signal analogique traité selon les principes de l'invention. Il pourrait aussi rester un signal numérique. L'invention vise également une utilisation d'un procédé conforme à celui décrit ci-après.

L'invention sera décrite dans le contexte du traitement des signaux de télévision pour plus de facilité, sans qu'on puisse y voir une quelconque limitation de la portée de l'invention. On connaît, dans les signaux de télévision pour visualiser des images sur des écrans cathodiques, des signaux de balayage horizontal, ainsi que de balayage vertical. Le signal de balayage horizontal est un signal appliqué sur des électrodes, ou des bobines, de déflexion d'un ou de plusieurs canons à électrons projetant des électrons d'une cathode vers un écran électroluminescent. Pour constituer une image, on provoque ainsi le balayage de l'écran afin de constituer un certain nombre de lignes empilées les unes en dessous des autres de haut en bas de l'écran.

Selon la résolution envisagée, ainsi que selon les normes de visualisation utilisées dans les différentes régions du monde, le nombre de lignes visualisées sur l'écran varie. Alors qu'on connaît actuellement des images avec 420 lignes ou 625 lignes, les nouvelles normes prévoient 1024 lignes, ou même 2048. Par ailleurs, la fréquence de rafraîchissement des images sur l'écran, 25 images par seconde, dépend également des standards et des qualités recherchés. On envisage notamment 50 images par seconde pour éviter les effets de scintillement.

Ces différents standards et ces différents besoins conduisent donc à des générateurs de signaux de balayage spécifiques pour chacune des utilisations.

En outre, on constate lors de la visualisation avec un écran cathodique, un problème de représentation d'image. Cette représentation ne s'effectue en fait que sous une forme distordue: la distorsion est une déformation en coussin. La déformation en coussin a, pour le balayage horizontal, l'inconvénient que la longueur balayée par la trace du canon à électron sur l'écran, le spot, n'est pas la même quelle que soit l'altitude de la ligne à balayer sur cet écran. En pratique, la longueur parcourue par le spot pour les lignes inférieures et supérieures est plus grande que pour les lignes médianes. La variation est en fait continue de sorte que l'image présente sur ses bords gauche et droit des profils en forme de parabole.

Ce phénomène est dû à l'application, sur les organes de déflexion des canons à électrons, de signaux identiques quelle que soit la ligne balayée. Ce phénomène est déjà connu et a déjà été corrigé par application, en fonction de la ligne à corriger, de supplément de tension ou de courant à ces organes de déflexion de manière à ce que le domaine d'exploration soit toujours le même quelle que soit l'altitude de la ligne. Par exemple un circuit dit TDA 815 de S.G.S. THOMSON MICROELECTRONICS est susceptible de produire les signaux de correction nécessaires. La mise en oeuvre de circuit de ce type nécessite cependant de le régler au préalable, notamment, en fonction d'une part du standard dans lequel va fonctionner le moniteur de visualisation à corriger, et d'autre part en fonction des altérations propres à ce moniteur de visualisation. Ceci conduit à une génération d'appareils dans lesquels le mode d'utilisation, les standards doivent être et sont prévus à l'avance.

Dans l'invention, on veut ne pas être lié par cette connaissance préalable et pouvoir s'adapter, même dans le futur, à n'importe quel standard qui pourrait apparaître. Le problème à résoudre dans le cas présent est donc, connaissant la courbe de déformation en coussin propre à un moniteur de visualisation, en quelque sorte la forme des paraboles à droite (et à gauche) de la distorsion de l'image représentée, de produire un signal (donc dans le cas présent un signal de correction) qui évolue dans le temps entre une valeur de départ et une valeur d'arrivée sur une période choisie, alors qu'on ne connaît pas a priori la durée de cette période choisie. Ceci est notamment le cas lorsque le standard passera de 25 images par seconde à 50, ou 40, images par seconde.

Le but à atteindre est donc de produire un système qui permette de dilater le temps, ou de le contracter. Jusqu'à présent, uniquement des circuits analogiques permettent d'obtenir de tels résultats. Ces circuits analogiques sont de plus seulement cantonnés à la production de signaux très simples: essentiellement sinusoïdaux. Il suffit dans ces circuits analogiques de modifier un paramètre réactif, une capacité ou une self réglables, agissant sur la fréquence, pour obtenir le résultat recherché.

Dans l'invention, on veut au contraire pouvoir modifier des signaux de forme quelconque, donc bien entendu pas nécessairement sinusoïdaux. Ce but est atteint dans l'invention en effectuant un comptage, pendant la période choisie à respecter, des impulsions délivrées par une horloge suffisamment rapide pour produire beaucoup d'impulsions pendant cette période. On obtient, après ce comptage pendant une première période de durée à respecter, un nombre A d'impulsions lié à la fréquence de cette horloge et à la durée de cette période. On divise ensuite ce nombre d'impulsions par un nombre entier 2N pour obtenir un nombre P d'impulsions correspondant au numérateur d'une fraction du nombre d'impulsions total. On compte ensuite des impulsions produites par cette horloge de façon à produire des lots ou paquets d'impulsions, de telle façon que le nombre P de ces impulsions dans ces lots corresponde exactement au numérateur de cette fraction. A chaque fois qu'un lot est complètement compté, on provoque la lecture dans une mémoire à accès aléatoire d'une valeur dont l'adresse correspond au rang du lot dans la période. La valeur lue de cette mémoire peut être quelconque mais, correspondant à un rang d'un lot qui est retrouvé régulièrement, elle sera relue périodiquement, ainsi que les précédentes et les suivantes à des adresses précédentes ou suivantes dans cette mémoire. En pratique, le rang est matérialisé par l'état d'un compteur qui compte le nombre de lots d'impulsions comptées. Une telle succession de valeurs lues dans la mémoire reconstitue le signal périodique recherché.

Un circuit de ce type est décrit dans le document GB-A-1 353 147. Il présente cependant l'inconvénient d'être monostandard. Dans le document "Fernsehtechnik ohne Ballast" dû à O LIMANN et Al., 1991, éditions Franzis, Munich,Allemagne; pages 498-523, il est par ailleurs évoqué la nécessité d'adapter les circuits de production de signaux de balayage pour moniteurs de télévisions aux différents standard en cours. Cependant cet enseignement est inopérant pour envisager l'adaptation aux standards futurs, dont on ne connaît pas encore l'allure au moment où on équipe le moniteur.

L'invention a donc pour objet un circuit de production de signaux de balayage pour moniteur de visualisation, muni d'un générateur de signaux périodiques de forme donnée comportant
- une horloge délivrant un nombre A d'impulsions pendant une période choisie pour ces signaux périodiques, A étant inférieur ou égal à 2^{N+M}, N et M étant des entiers,
- un premier compteur numérique binaire pour compter des lots de P impulsions d'horloge avec M bits de comptage, 2^{M} étant plus grand ou égal à P, recevant sur son entrée de comptage les impulsions de l'horloge, les P impulsions d'horloge se produisant pendant des fractions 1/(2^{N}) de ladite période choisie, et délivrant un signal de lot à chaque comptage d'un lot,
- un deuxième compteur numérique binaire cyclique de N bits, recevant sur son entrée ledit signal de lot, et produisant à chaque comptage d'un signal de lot un signal d'adresse,
- une mémoire à au moins 2^{N} adresses à accès aléatoire munie d'une entrée d'adresse et d'une sortie de données, raccordée par son entrée d'adresse à la sortie du deuxième compteur et délivrant sur sa sortie des signaux binaires correspondant aux signaux d'adresse produits,
- et un circuit convertisseur relié à la sortie de la mémoire pour produire ledit signal périodique en fonction des signaux binaires reçus, avec en outre les caractéristiques énoncées dans la revendication 1.

L'invention sera mieux comprise à la lecture de la description qui suit et l'examen des figures qui l'accompagnent. Celles-ci ne sont données qu'à titre indicatif et nullement limitatif de l'invention. Les figures montrent:
- figure 1: un circuit permettant le comptage des impulsions produites par une horloge pendant une période choisie. Ce circuit comporte également un moyen pour diviser le nombre des impulsions comptées pour produire un nombre d'impulsions réduit correspondant à celles qui se présentent dans un lot d'impulsions;
- figure 2: un circuit de mise en oeuvre de l'invention dans une utilisation pour corriger la déformation en coussin d'un moniteur de télévision;
- figure 3: un organigramme d'actions mises en oeuvre par un circuit de commande des circuits des figures 1 et 2;
- figure 4: une représentation schématique d'un circuit à microprocesseur utilisable pour mettre en oeuvre l'invention.

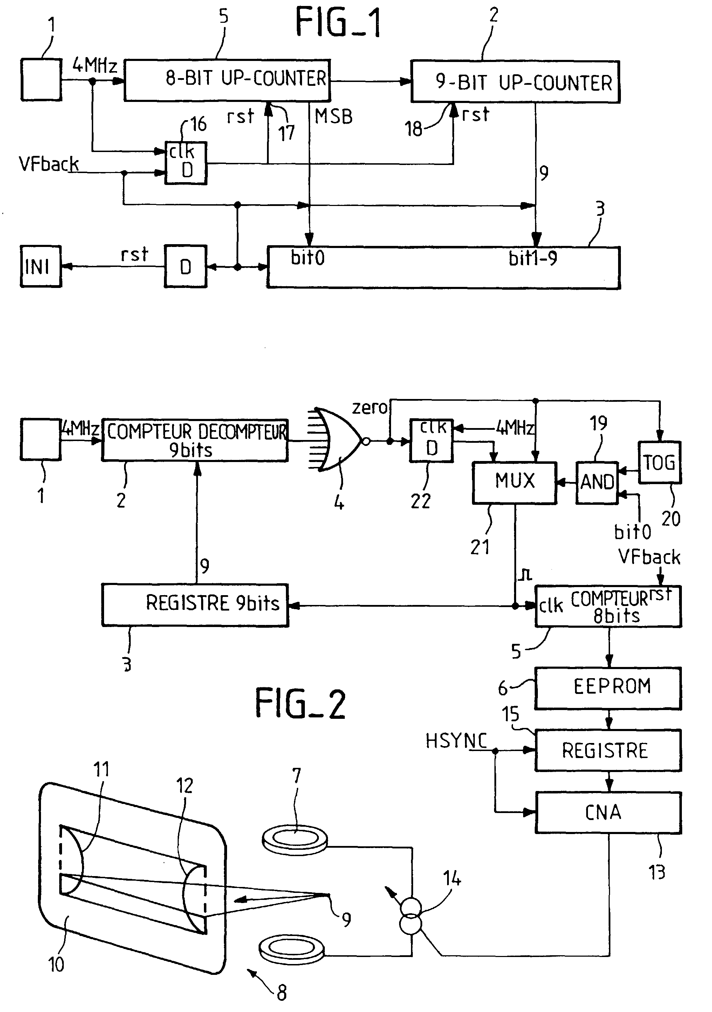

La figure 2 montre un générateur de signaux périodiques, de période quelconque mais de forme donnée selon l'invention. Ce circuit comporte une horloge 1 délivrant un grand nombre d'impulsions pendant une période choisie pour les signaux périodiques. Par exemple, dans une application à la correction en coussin d'un moniteur de visualisation le signal périodique de balayage de trame est de l'ordre de 25 millisecondes (pour 40 images par seconde). En choisissant une horloge 1 oscillant à 4 MHz on peut obtenir jusqu'à 100 000 impulsions par trame. On considère ici une trame équivalent à une image et donc à deux demi-trames. Le générateur comporte également un premier compteur numérique binaire 2 avec M cellules en cascade. Dans un exemple, M vaut 9. Le compteur 2 est un compteur binaire comptant en comptage binaire naturel. Il pourrait cependant être également un compteur de type bit à bit. Le compteur 2 a M sorties délivrant des signaux binaires représentatif de l'état des M cellules de ce compteur. Le compteur 2 est en pratique un décompteur qui est préchargé avant le décomptage par le contenu d'un registre 3 (d'un même nombre de bits). Une fois que le compteur 2 a été préchargé, il décompte au rythme des impulsions de l'horloge 1 son contenu jusqu'à atteindre un état zéro. Le contenu du compteur est P avec P inférieur ou égal à 2^{M}.

L'état zéro peut, dans un exemple schématique, être détecté par la présence d'une porte 4 de type NON OU à M entrées reliées aux M sorties ou états de compteur. La sortie de cette porte 4 passe temporairement à l'état 1 quand les M sorties du compteur 2 sont à zéro. La sortie de la porte 4 est elle-même utilisée pour déclencher le chargement du compteur 2 avec le contenu du registre 3. Autrement dit, à chaque opération de décomptage d'un lot d'impulsion dont le nombre correspond à la valeur chargée dans le registre 3, le décomptage est repris. En conséquence, la porte NON OU 4 délivre une impulsion dès qu'un lot est compté. Cette impulsion de comptage de lot est transmise ensuite à un deuxième compteur 5 qui est un compteur par N avec N cellules. Dans un exemple N vaut 8. Le compteur 5 compte en comptage binaire naturel. A chaque fois que le compteur 5 reçoit une impulsion il délivre sur ses N sorties de comptage un mot de comptage de N bits équivalent à une adresse. Ce mot de comptage est appliqué en entrée d'adresse d'une mémoire à accès aléatoire 6. La mémoire 6 délivre, quand elle est ainsi adressée, un mot binaire équivalent à un signal binaire.

Ce signal binaire, dans l'utilisation particulièrement décrite dans la présente invention, est appliqué sur des bobines magnétiques de déviation horizontale 7 d'un moniteur de type cathodique 8. Les bobines 7 provoquent le balayage horizontal. Lorsque ces bobines 7 sont alimentées par un courant constant, elles provoquent, pour une durée donnée, un balayage dont la longueur dépend de l'altitude sur l'écran de la ligne balayée.

Ceci s'explique aisément parce que cette déviation est équivalente à un angle de balayage. Etant donné que la cathode 9 de l'écran cathodique 8 est très proche de l'écran proprement dit 10, il y a un chemin notablement plus grand entre cet écran 10 et la cathode 9 pour les lignes les plus basses et les plus hautes de l'écran que pour les lignes médianes. En conséquence, pour un même angle (ou un même demi-angle) de balayage donné, le chemin parcouru étant plus grand, la déviation du spot est plus grande. Le résultat de ce phénomène est que la longueur des lignes balayées est, en fonction de sa hauteur sur l'écran, sensiblement inscrite dans les contours désignés par les arcs de parabole 11 et 12 sur l'écran 10.

Dans l'invention on a dans le cas présent remarqué que ce type de défaut était essentiellement dû à la géométrie de l'écran proprement dit (la distance écran 10-cathode 9). Il n'est pas du tout lié au mode de balayage lui-même, c'est à dire qu'on visualise 400 lignes par image, 625 ou même que l'on visualise 25 ou 50 images par seconde.

Le signal qui est élaboré à la sortie de la mémoire 6 par un convertisseur numérique analogique 13, est en pratique, additionné au signal de balayage habituel appliqué sur les bobines 7. Ce type d'addition est de type connu. Il est schématiquement représenté par une alimentation en courant 14 des bobines 7 dont l'intensité produite dépend de la valeur du signal délivré par un convertisseur numérique analogique 13. Etant donné que pour les lignes centrales, la distance normalement balayée est inférieure à la distance utile, le courant qui doit être appliqué sur les bobines 7 doit recevoir un supplément d'intensité. En fait un autre circuit de correction doit également être prévu: celui qui consiste à faire décaler sur un côté le point de départ du balayage, du côté où la ligne commence à être balayée. On négligera ici ces effets puisque, ce qui est important au regard de l'invention, est de produire le signal périodique lui-même. Les circuits existant dans l'appareil 8 sont déjà capables de faire les corrections adéquates une fois qu'ils sont alimentés par les bons signaux de correction.

Dans l'invention on va donc mesurer la période inconnue: cette période est celle correspondant à une trame de signal vidéo reçu. Puis on va tenir compte de cette mesure pour corriger, en un signal périodique de période ainsi mesurée, les signaux de balayage.

Dans l'invention, on a décidé par ailleurs de répartir la correction à appliquer sur l'écran d'une manière discrète, en un nombre réduit de pas. Ce nombre de pas est de préférence choisi inférieur au nombre minimum de lignes que le moniteur de télévision est susceptible de montrer. Compte tenu que 400 lignes est actuellement le minimum, on a choisi une correction en 256 pas. Autrement dit, pour une période donnée (mais inconnue et mesurée) de balayage d'une trame, on décide de diviser cette période en 256 sous-périodes élémentaires. Pour chacune de ces sous-périodes, naturellement ordonnées dans le temps les unes par rapport aux autres, on peut faire correspondre une ligne, ou un groupe de lignes de balayage horizontal, juxtaposées les unes aux autres sur l'écran 10. En conséquence cette ligne, ou ces lignes, doivent recevoir une même correction. Ceci est le but du signal produit par la mémoire 6. A chaque fois qu'on change de ligne ou de groupe de lignes, le compteur 5 change de contenu. Le cycle est recommencé à chaque période.

Il y a une relation directe entre le choix particulier de N = 8 et le nombre 256 de pas puisqu'on a décidé de diviser la période en 256 sous-périodes. En effet 2⁸ = 256.

Dans ce but, la sortie de la mémoire 6 n'est pas reliée directement au convertisseur numérique analogique 13 mais est reliée à un registre 15 qui stocke, pendant toute la durée d'une sous-période correspondante à une ligne ou un groupe de lignes, une valeur de correction. Dans ces conditions, un signal de synchronisation horizontale HSYNC est appliqué au registre 15 pour prélever de ce registre une valeur qui à chaque fois doit être transformée par le convertisseur 13. Le signal HSYNC est également appliqué au convertisseur 13, pour en déclencher la conversion. A chaque fois que le balayage arrive en début de ligne, le registre 15 est lu. Dès qu'un groupe de lignes a été affiché sur l'écran 10, le compteur décompteur 2 a produit un bit, le compteur 5 a changé d'état par comptage de ce bit, la mémoire 6 a été adressée à une autre adresse, et le registre 15 est chargé par une autre valeur. Dans ces conditions, au début de la ligne suivante, le contenu du registre 15 n'est plus le même. Le convertisseur 13 convertit alors la nouvelle valeur. De cette manière on obtient un profil en forme d'escalier pour compenser les effets des contours 11 et 12. Dans le cas où N = 8 et où on a 400 lignes à afficher, les groupes de lignes ne seront pas toujours identiques, ils comprendront quelquefois deux lignes, quelquefois une seule ligne. Le signal périodique produit par la mémoire 6 évolue naturellement selon la période évoquée. L'adaptation au nombre de lignes d'affichage est automatique en prélevant aux signaux HSYNC,le contenu du registre 15.

Le circuit de la figure 2 est le circuit selon l'invention, mettant en oeuvre le générateur de signaux périodiques.

On va maintenant montrer à l'aide de la figure 1 comment on acquiert le contenu du registre 3. Pour simplifier l'explication, on considérera que les compteurs 2 et 5 sont maintenant organisés différemment. Le compteur 5 est monté maintenant en amont du compteur 2. Il reçoit en entrée le signal de l'horloge 1 et, chaque fois que son bit de poids le plus fort change d'état, il provoque le comptage d'une unité dans le compteur 2. Si on regarde ce qui se passe en effectuant un tel comptage pendant une période donnée (mais inconnue), on constate qu'à l'issue du comptage, le compteur 2 est chargé avec un nombre égal au nombre de fois que le compteur 5 a fait de tours. En pratique, comme le compteur 5 est un compteur par 8 bits, il compte 256 impulsions par tour. Le compteur 2 à l'issue de la mesure emmagasine ce nombre d'impulsions qu'il faut par lot pour avoir 256 lots dans la période donnée. Pour se limiter au comptage de ce qui se passe pendant une seule période, on déclenche à l'aide d'une bascule D 16 des entrées de remise à zéro 17 et 18 des compteurs 5 et 2. La bascule 16 reçoit d'une part le signal de l'horloge 1 et d'autre part un signal de fin de trame VFback. Chaque fois qu'on a vu une image entière, la bascule D 16 reçoit le signal VFback et change d'état d'une manière impulsionnelle. On peut dans ces conditions remettre à zéro le compteur 5 et le compteur 2. On utilise par ailleurs le signal de fin de trame VFback pour charger le contenu d'un registre 3 avec l'état du compteur 2 au moment où ce retour de trame se produit. Le compteur 2 étant un compteur à 9 bits, le registre 3 est un registre à au moins 9 bascules pour enregistrer le contenu des bits 1 à 9 du compteur 2.

Dans une variante particulièrement intéressante, on a retenu une précision un peu plus grande de la mesure de la durée de la période déterminée. En effet, il est tout à fait possible que la période inconnue à mesurer ne corresponde pas à un nombre exact de lots de 256 impulsions de l'horloge 1 à 4 MHz. Notamment, il est possible que, dans le pire des cas, on effectue ainsi une erreur de 128 impulsions parce que cette durée a correspondu à un nombre entier de fois 256 impulsions plus une fois 128 impulsions. De manière à tenir compte, d'une façon qui sera expliquée plus loin, de l'état partiellement compté du compteur 5, avant sa mise à zéro, on charge, au moment du retour de trame, le contenu du bit de poids fort du compteur 5 dans une bascule supplémentaire du registre 3. Cette bascule est dite bascule du bit 0. L'état de ce bit O est utilisé en entrée d'une porte ET 19, figure 2, dont la sortie est utilisée pour valider la transmission d'un ordre élaboré par un circuit de basculement 20. L'idée est alors dans ce cas de compter des lots non plus toujours de P impulsions mais au contraire tantôt de P et tantôt de P+1 impulsions. Pour ce faire, une fois sur deux, on déclenche le changement d'état du compteur 5 une impulsion plus tard qu'au bout de la durée finissant au comptage de P impulsions, (P étant le contenu binaire contenu dans le registre 3 à M (M = 9) bits). Dans ce cas, au lieu de compter P on compte P+1. Ainsi, 128 fois sur les 256 fois possibles, on comptera un bit de plus. Dans ces conditions, le rechargement du compteur 2 par le contenu du registre 3 est effectué au moment de la transmission au compteur 5 du signal délivré par un multiplexeur 21.

De cette façon, on effectue une correction telle qu'il n'y a pas un décalage, ou une distorsion, dans la correction elle-même. Si on n'effectuait pas ce type de correction, il y aurait un décalage, pas vraiment gênant, mais néanmoins existant dans la correction parabolique.

Dans ce but, le circuit de basculement 20 est un circuit du type bistable et il reçoit le signal délivré par la porte 4. Il change d'état une fois sur deux, si par ailleurs le bit de poids fort du compteur 5 était à 1 au moment de la capture. En conséquence, la porte ET 19 change alors d'état une fois sur deux. La porte ET 19 commande un multiplexeur 21 qui reçoit en entrée le signal issu de la porte 4 d'une part directement et d'autre part transmis par une bascule de type D 22. La bascule D 22 reçoit le signal d'horloge à 4 MHz également. La bascule D22 reçoit également en entrée le signal issu de la porte 4. La bascule D 22 transmet à sa sortie le signal disponible à la porte 4 après avoir reçu une impulsion de l'horloge sur son entrée d'horloge. Ceci est bien équivalent à compter une impulsion d'horloge supplémentaire puisqu'en pratique cette bascule D retarde ainsi la transmission du comptage des 2^{N} adresses.

La porte 19 commande donc le multiplexeur 21 de telle façon qu'il transmette directement soit le signal issu de la porte 4 au compteur 5, soit le signal en provenance de la bascule D 22. Par contre, si le bit de poids le plus fort du compteur 5 au moment de l'acquisition, figure 1, n'est pas 1 mais est 0, la porte 19 délivre O en permanence en sortie. Dans ce cas, le multiplexeur 21 connecte en permanence directement la sortie de la porte 4 à l'entrée du compteur 5.

De préférence, le compteur 5 est lui-même remis à zéro au moment du changement de trame en recevant le signal VFback sur son entrée de remise à zéro.

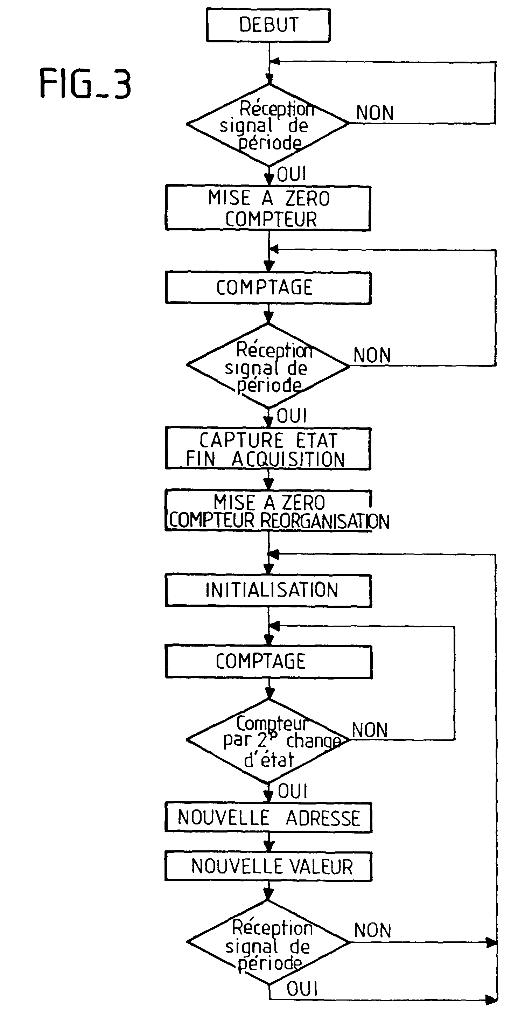

La figure 3 montre l'organigramme d'utilisation de l'invention. Au début pendant une première phase, on va faire l'acquisition du contenu du registre 3 mesuré par le compteur 2. La durée de cette première phase correspond par exemple à une trame. On attend en conséquence de recevoir un signal de période. Dans le cas présent, il s'agit d'un signal de trame: VFback. Lorsqu'on le reçoit, on met à zéro les compteurs à l'aide de la bascule 16. Puis on provoque le comptage tant que l'on ne reçoit pas une deuxième fois le signal de période. Ce faisant, le compteur 5 évolue, compte des lots de 2^{N} = 2⁸ = 256 impulsions d'horloge et incrémente le contenu du compteur 2 pour que ce dernier compte un nombre d'impulsions qu'il lui faudra par lot pour avoir au total 256 lots dans la période. Lorsqu'on reçoit à nouveau le signal de période (ici le signal VFback), on capture l'état du compteur 2 dans le registre 9 en appliquant ce signal de période aux entrées de transfert du registre 3. On capture également le bit 0.

Ceci termine la phase de mesure de la période. On remarque que cette phase de mesure est particulièrement intéressante si, passant d'un programme de télédiffusion diffusé selon une norme donnée, un utilisateur aboutit sur un programme diffusé avec une autre norme: une autre façon plus ou moins fine de montrer les images. A chaque fois le temps utile pour connaître les caractéristiques de l'image est d'une période d'image. Ceci est insensible et est tout à fait accepté par l'utilisateur quand il provoque, notamment au moyen de sa télécommande, un changement de chaîne.

Une fois que l'état du compteur 2 a été capturé, on met à zéro les compteurs et on réorganise les connexions des compteurs de manière à ce que le schéma devienne maintenant celui de la figure 2. En pratique, comme on le verra par la suite, on a affaire à un système à microprocesseur et donc cette réorganisation est assez simple. Puis on initialise le compteur décompteur 2 en lui injectant le contenu du registre 3. On effectue ensuite le décomptage. Dès qu'on obtient un décomptage de P impulsions d'horloge, on provoque le changement d'état du compteur 5. Ce changement d'état conduit à une nouvelle valeur extraite de la mémoire 6 chargée dans le registre 15. Le registre 15 est lu au rythme du signal HSYNC, au rythme du balayage des lignes. Ce phénomène se reproduit tant qu'on ne reçoit pas à nouveau un signal de fin de période.

Lorsqu'on reçoit un signal de fin de période, on retourne à l'initialisation. Ceci signifie qu'à ce moment, on recommence à charger le compteur 2 avec le contenu du registre 3 et ainsi de suite. On peut néanmoins procéder de deux façons. Soit on compte 2^{N} différents changements d'état pour commencer un nouveau cycle de 2^{N} états. Soit on fait plutôt confiance au signal de fin de période VFback pour se resynchroniser. Dans tous les cas, on réinitialise le compteur 2 avec le contenu du registre 3 au début de la période.

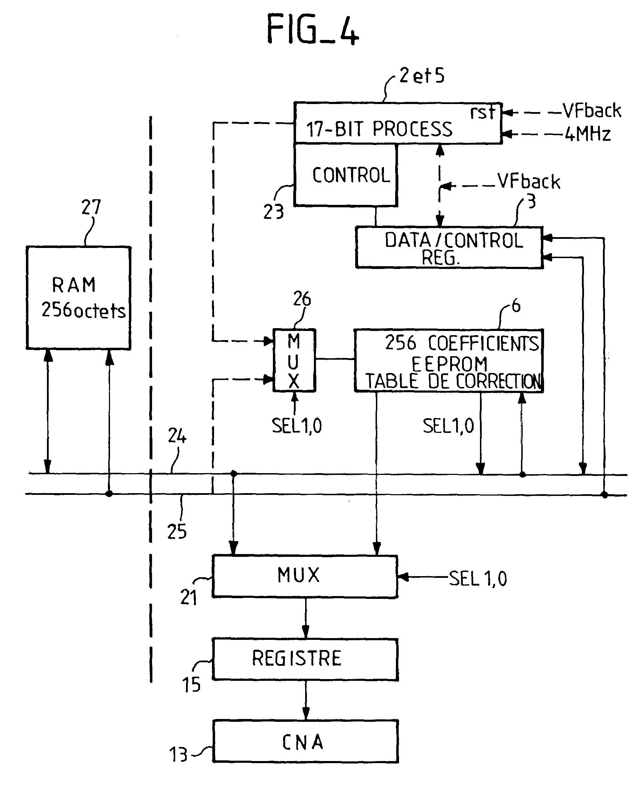

La figure 4 montre une représentation d'une mise en oeuvre de l'invention avec un circuit à microprocesseur et avec un bus. Dans cette représentation, les deux compteurs 5 et 2 sont constitués en un seul compteur à N+M bits = 17 bits dans l'exemple. Ce compteur reçoit des commandes par un processeur 23 qui commande également le registre de commande et de données 3. Le compteur reçoit les signaux de l'horloge à 4 MHz et de signal de trame VFback: le signal de période. Le circuit comporte également un bus de donnée 24, un bus d'adresse 25, et un multiplexeur d'entrée sortie 26. Le multiplexeur d'entrée sortie permet de charger dans la mémoire 6 d'un circuit attaché à un moniteur 8 des coefficients de correction mesurés sur ce moniteur et préalablement stocké dans une mémoire 27 reliée au bus 24 et 25. Le multiplexeur 26 permet également de gérer la mémoire 6 à partir du microprocesseur 6. La réorganisation de la connexion des compteurs est effectué par le microprocesseur 23 avec le principe suivant. Chaque connexion des organes des figures 1 et 2 est relié aux autres organes par un circuit comportant une porte ET. Cette porte ET reçoit le signal à transmettre ainsi qu'un signal de commande actif ou inactif. Elle ne transmet le signal à transmettre que dans le premier cas. Avec ce signal de commande actif pendant la phase de mesure et inactif pendant la phase d'utilisation on peut facilement réaliser la commutation. Par exemple, à chaque changement de chaîne, le signal de commande sera actif pendant uniquement la durée de la première trame. On peut, dans d'autres applications, imaginer une entrée de forçage pour appliquer ce signal de commande à volonté.

## Revendications

1. Circuit de production de signaux de balayage pour moniteur de visualisation, muni d'un générateur de signaux périodiques de forme donnée comportant
- une horloge (1) délivrant un nombre A d'impulsions pendant une période choisie pour ces signaux périodiques, A étant inférieur ou égal à 2^{N+M}, N et M étant des entiers,
- un premier compteur (2) numérique binaire pour compter des lots de P impulsions d'horloge avec M bits de comptage, 2^{M} étant plus grand ou égal à P, recevant sur son entrée de comptage les impulsions de l'horloge, les P impulsions d'horloge se produisant pendant des fractions 1/(2^{N}) de ladite période choisie, et délivrant un signal de lot à chaque comptage d'un lot,
- un deuxième compteur (5) numérique binaire cyclique de N bits, recevant sur son entrée de comptage ledit signal de lot, et produisant à chaque comptage d'un signal de lot un signal d'adresse,
- une mémoire (6) à au moins 2^{N} adresses à accès aléatoire munie d'une entrée d'adresse et d'une sortie de données, raccordée par son entrée d'adresse à la sortie du deuxième compteur et délivrant sur sa sortie des signaux binaires correspondant aux signaux d'adresse produits,
- et un circuit (13) convertisseur relié à la sortie de la mémoire pour produire ledit signal périodique en fonction des signaux binaires reçus,
caractérisé en ce que
- le circuit de production comporte un circuit pour acquérir la valeur de P sur base du comptage du nombre A pendant la période choisie, et en ce que
- le premier compteur (2) est programmable par ce circuit de production, à cette valeur de P ainsi acquise.

2. Circuit selon la revendication 1, caractérisé en ce que le circuit (13) convertisseur comporte en entrée un registre (15) de transfert relié par son entrée à la sortie de la mémoire à accès aléatoire, et muni d'une entrée (HSYNC) de commande de transfert.

3. Circuit selon l'une des revendications 1 ou 2, caractérisé en ce que le deuxième compteur (5) comporte une entrée de remise à zéro déclenchée par un signal (VFback) à la période choisie.

4. Circuit selon l'une des revendications 1 à 3, caractérisé en ce qu'il comporte un registre (3) de forçage, pour forcer le premier compteur dans un état donné au démarrage du comptage des impulsions d'un lot, et un circuit (4) de comparaison pour comparer à tout moment un état du compteur à un état donné.

5. Circuit selon la revendication 4, caractérisé en ce que le premier compteur (2) est un décompteur et en ce que le circuit de comparaison comporte une porte (4) OU ou NON OU à M entrée.

6. Circuit selon l'une des revendications 4 ou 5, caractérisé en ce qu'il comporte un circuit logique (23) pour connecter différemment, dans un autre mode de connexion, le premier et le deuxième compteur et le registre de forçage.

7. Circuit selon la revendication 6, caractérisé en ce que dans l'autre mode de connexion
- le deuxième compteur (5) numérique binaire cyclique de N bits reçoit sur son entrée de comptage le signal d'horloge (1),
- le premier compteur (2) numérique binaire avec M bits reçoit sur son entrée de comptage des impulsions de comptage provenant du dernier étage du deuxième compteur (5), au
- les deux compteurs sont reliés au registre (3) de forçage destiné à recevoir et se charger d'un signal de forçage correspondant au contenu P du premier compteur (2) et d'une partie du deuxième compteur, le registre de forçage comportant une entrée de commande déclenchée par un signal (VFback) à la période choisie.

8. Circuit selon l'une des revendications 1 à 7 caractérisé en ce que le deuxième compteur (5) comporte une entrée de remise à zéro déclenchée par un signal de synchronisation de trame (VFback) du moniteur de visualisation.

## Patentansprüche

1. Erzeugerschaltkreis für Ablenksignale für Anzeigebildschirme mit einem Generator von periodischen Signalen vorgegebener Form, der umfaßt:
- einen Taktgeber (1) für die Ausgabe einer Anzahl A Impulse während einer gewählten Dauer für die periodischen Signale, wobei A kleiner oder gleich 2^{N+M} ist, wobei N und M ganze Zahlen sind,
- einen ersten numerischen Binärzähler (2) zum Zählen einer Folge von P Impulsen vom Taktgeber mit M-Bit Zählbreite, wobei 2^{M} gößer oder gleich P ist, der über seinen Zähleingang die Taktgeberimpulse empfängt, wobei die P Impulse des Taktgebers sich während 1/(2^{N}) Bruchteilen der besagten gewählten Dauer ereignen, und der ein Folgensignal bei jeder Zählfolge ausgibt,
- einen zweiten numerischen Binärzähler (5) mit N-Bit Zyklus, der über seinen Zähleingang das besagte Folgensignal einliest und bei jeder Zählung eines Folgensignals ein Adreßsignal ausgibt,
- einen Speicher (6) mit wenigstens 2^{N} Adressen, auf die beliebig zugegriffen werden kann, der mit einem Adreßeingang und einem Datenausgang versehen ist, der über seinen Adreßeingang mit dem Ausgang des zweiten Zählers verbunden ist und über seinen Ausgang Binärsignale ausgibt, die den erzeugten Adreßsignalen entsprechen, und
- einen Konverterschaltkreis (13), der mit dem Ausgang des Speichers verbunden ist, um das besagte periodische Signal in Abhängigkeit von den empfangenen Binärsignalen zu erzeugen,
dadurch gekennzeichnet, daß
der Erzeugerschaltkreis einen Schaltkreis zur Aufnahme des Wertes P auf der Basis der Zählung der Zahl A während einer gewählten Dauer umfaßt, und dadurch daß
- der erste Zähler (2) über den Erzeugerschaltkreis auf den Wert P, der so aufgenommen wurde, programmierbar ist.

2. Schaltkreis nach Anspruch 1, dadurch gekennzeichnet, daß der Konverterschaltkreis (13) am Eingang ein Übertragungsregister (15) umfaßt, das über seinen Eingang mit dem Ausgang des Speichers mit beliebigem Zugriff verbunden ist, und ausgestattet ist mit einem Übertragungssteuerungseingang (HSYNC).

3. Schaltkreis nach einem der Ansprüche 1 oder 2, dadurch gekennzeichnet, daß der zweite Zähler (5) einen Eingang für das Zurücksetzen auf Null umfaßt, das ausgelöst wird durch ein Signal (VFback) nach der gewählten Dauer.

4. Schaltkreis nach einem der Ansprüche 1 bis 3, dadurch gekennzeichnet, daß er ein Setzregister (3) für das Setzen des ersten Zählers in einen vorgegebenen Zustand beim Starten des Zählens der Impulsfolge und einen Komparatorschaltkreis (4) zum Vergleichen des Zählerzustandes mit einem vorgegebenen Zustand zu jeder Zeit umfaßt.

5. Schaltkreis nach Anspruch 4, dadurch gekennzeichnet, daß der erste Zähler (2) ein Abwärtszähler ist, und dadurch, daß der Komparatorschaltkreis ein ODER- oder NICHT ODER-Gatter (4) mit M Eingängen umfaßt.

6. Schaltkreis nach einem der Ansprüche 4 oder 5, dadurch gekennzeichnet, daß er einen Logikschaltkreis (23) umfaßt, um in einem anderen Verbindungsmodus den ersten und zweiten Zähler und das Setzregister unterschiedlich zu verbinden.

7. Schaltkreis nach Anspruch 6, dadurch gekennzeichnet, daß im anderen Verbindungsmodus
- der zweite numerische Binärzähler (5) mit einem N-Bit Zyklus über seinen Zähleingang das Signal des Taktgebers (1) empfängt,
- der erste numerische Binärzähler (2) mit M-Bit über seinen Zähleingang die Zählpulse empfängt, die von der letzten Stufe des zweiten Zählers (5) kommen,
- die zwei Zähler verbunden sind mit dem Setzregister (3), um ein Setzsignal zu empfangen und zu laden, das dem Inhalt P des ersten Zählers (2) und einem Teil des zweiten Zählers entspricht, wobei das Setzregister einen Eingang zur Steuerung umfaßt, die durch ein Signal (VFback) nach gewählter Dauer ausgelöst wird.

8. Schaltkreis nach einem der Ansprüche 1 bis 7, dadurch gekennzeichnet, daß der zweite Zähler (5) einen Eingang für das Zurücksetzen auf Null mittels Signal zur Synchronisation des Teilbildes (VFback) des Fernsehbildschirms umfaßt.

## Claims

1. Circuit for producing scanning signals for a display monitor equipped with a generator of periodic signals of given shape having
- a clock (1) supplying a number A of pulses during an interval selected for these periodic signals, A being less than or equal to 2^{N+M}, N and M being integers,
- a first binary digital counter (2) for counting the batches of P clock pulses with M counting bits, 2^{M} being greater than or equal to P, receiving at its counting input the pulses from the clock, the P clock pulses being produced during fractions 1/(2^{N}) of the said selected interval, and supplying a batch signal each time a batch is counted,
- a second N-bit cyclic binary digital counter (5), receiving the said batch signal at its counting input and producing an address signal each time a batch signal is counted,
- a random access memory (6) with at least 2^{N} addresses, provided with an address input and a data output, connected by its address input to the output of the second counter and supplying at its output binary signals corresponding to the address signals produced,
- and a converter circuit (13) connected to the output of the memory in order to produce the said periodic signal in accordance with the binary signals received,
characterised in that
- the production circuit has a circuit for acquiring the value of P based on the counting of the number A during the selected interval, and in that
- the first counter (2) is programmable by this production circuit, with this value of P thus acquired.

2. Circuit according to Claim 1, characterised in that the converter circuit (13) has as an input a transfer register (15) connected by its input to the output of the random access memory, and provided with a transfer control input (HSYNC).

3. Circuit according to one of Claims 1 or 2, characterised in that the second counter (5) has a reset-to-zero input triggered by a signal (VFback) at the selected interval.

4. Circuit according to one of Claims 1 to 3, characterised in that it has a forcing register (3) for forcing the first counter into a given state at the start of the counting of the pulses in a batch, and a comparison circuit (4) for at any moment comparing a state of the counter with a given state.

5. Circuit according to Claim 4, characterised in that the first counter (2) is a downcounter and in that the comparison circuit has an OR or NOR gate (4) with M inputs.

6. Circuit according to one of Claims 4 or 5, characterised in that it has a logic circuit (23) for connecting differently, in another connection mode, the first and the second counter and the forcing register.

7. Circuit according to Claim 6, characterised in that, in the other connection mode,
- the second N-bit cyclic binary digital counter (2) receives the clock signal (1) at its counting input,
- the first M-bit binary digital counter (2) receives at its counting input counting pulses coming from the last stage of the second counter (5),
- the two counters are connected to the forcing register (3), designed to receive and process a forcing signal corresponding to the content P of the first counter (2) and of part of the second counter, the forcing register having a control input triggered by a signal (VFback) at the selected interval.

8. Circuit according to one of Claims 1 to 7, characterised in that the second counter (5) has a reset-to-zero input triggered by a frame synchronisation signal (VFback) from the television monitor.
